(19) Europäisches Patentamt

**European Patent Office**

**Office européen des brevets**

(11) Veröffentlichungsnummer: **0 296 371 B1**

(12) **EUROPÄISCHE PATENTSCHRIFT**

(45) Veröffentlichungstag der Patentschrift: **23.12.92**

(21) Anmeldenummer: **88108399.2**

(22) Anmeldetag: **26.05.88**

(51) Int. Cl.⁵: **H01L 31/10**

(54) **Photodetektor für Ultraviolett und Verfahren zur Herstellung.**

(30) Priorität: **22.06.87 CH 2358/87**
**14.04.88 CH 1387/88**

(43) Veröffentlichungstag der Anmeldung:
**28.12.88 Patentblatt 88/52**

(45) Bekanntmachung des Hinweises auf die
Patenterteilung:
**23.12.92 Patentblatt 92/52**

(84) Benannte Vertragsstaaten:
**AT CH DE FR GB IT LI NL SE**

(56) Entgegenhaltungen:
**EP-A- 0 152 353    EP-A- 0 165 764**
**DE-A- 2 730 477    DE-A- 3 345 189**
**DE-A- 3 432 801    GB-A- 2 127 223**
**US-A- 3 852 591    US-A- 4 072 544**
**US-A- 4 544 939    US-A- 4 594 605**

(73) Patentinhaber: **Landis & Gyr Betriebs AG**

**CH-6301 Zug(CH)**

(72) Erfinder: **Radivoje, Popovic**
**Fridbach 1**
**CH-6300 Zug(CH)**

(74) Vertreter: **Müller, Hans-Jürgen, Dipl.-Ing. et al**
**Müller, Schupfner & Gauger Maximilianstrasse 6 Postfach 10 11 61**
**W-8000 München 1(DE)**

## Beschreibung

Die Erfindung bezieht sich auf einen Photodetektor der im Oberbegriff des Patentanspruchs 1 genannten Art, wie er beispielsweise in einem eine Flamme überwachenden Gerät Verwendung findet.

Photodetektoren aus Halbleitermaterial sind bekannt. Sie weisen eine ausserordentlich hohe Empfindlichkeit für infrarote Strahlung mit einer Wellenlänge von 800 nm auf. Die Empfindlichkeit dieser Photodetektoren für Licht nimmt mit kürzerer Wellenlänge rasch auf vernachlässigbare Werte ab, weil die Reflexionsverluste an der Eintrittsstelle in den Halbleiter und die Absorption der Strahlung im Kristall stark ansteigen. So beträgt beispielsweise in Silizium bei Raumtemperatur die Eindringtiefe für Strahlung von 800 nm etwa 10'000 nm, für violette Strahlung von 400 nm etwa 200 nm und im ultravioletten Bereich bei einer Wellenlänge von 200 nm aber nur noch 10 nm. (H F. Wolf, Semiconductors, Wiley-Interscience 1971, ISBN 0-471-95949-9). Zusätzlich gehen durch Rekombination in der Nähe der Oberfläche des Halbleiters Ladungsträgerpaare verloren. Diese Verluste durch Rekombination betreffen daher vor allem Ladungsträger, die von der kurzwelligeren Strahlung erzeugt werden.

In Photodetektoren, deren Halbleiterstrukturen einen pn- oder np-Uebergang unmittelbar unter der Oberfläche aufweisen, werden diese Rekombinationsverluste nahe der Oberfläche stark reduziert. T. E. Hansen in "Silicon Detectors for the UV- and Blue Spectral Regions with Possible Use as Particle Detectors" [Nuclear Instruments & Methods in Physics Research Vol. A235 (1985) p. 249-253] beschreibt solche Photodetektoren aus n- oder p-leitendem Silizium, die auch auf Strahlen des ultravioletten Spektralbereichs empfindlich sind.

Die aus p-leitendem Silizium hergestellten Photodetektoren weisen eine MOS-Struktur auf. Die MOS-Struktur bildet natürlicherweise an der Grenzfläche zwischen dem Isolator und dem p-leitenden Halbleiter eine sehr dünne $n^+$-Schicht, einen Leitungskanal, aus.

Die aus n-leitendem Silizium als eine Diode hergestellten Photodetektoren weisen an der Eintrittsstelle der Strahlung unmittelbar an der Oberfläche eine dünne, mittels Ionenbeschuss mit Bor dotierte $p^+$-leitende Schicht auf, die mit dem Substrat einen pn-Uebergang bildet.

Anstelle des pn-Uebergangs ist auch ein Schottky-Kontakt zum n-leitenden Silizium verwendbar.

Eine als Photodiode für infrarote Strahlung verwendete PIN-Diode weist bekanntlich eine zwischen einem p-leitenden und einem n-leitenden Gebiet eingeschobene Zone auf, in der die Eigenleitung des Halbleiterkristalls vorherrschend ist.

Diese Zone ist typisch 50 $\mu$m breit und wird in der Fachwelt als intrinsisch leitendes Gebiet bezeichnet.

Die Reflexionsverluste lassen sich durch einen in der Dicke der Lichtwellenlänge angepassten Belag als ein Eintrittsfenster mit einem niedrigeren Brechungsindex als das Halbleitermaterial verkleinern (T. Ando & C-K Fong "Photoresponses in $In_2O_3$-Transparent Gate MOS Capacitors", IEEE Transactions on Electron Devices, Vol. ED-29, No. 8, August 1982, p. 1161).

UV-empfindliche Halbleiter-Photodetektoren gemäss dem Stand der Technik weisen für rotes, langwelligeres Licht eine immer noch um Faktoren höhere Empfindlichkeit auf als für kurzwelligeres Licht mit einer Wellenlänge kleiner als 400 nm (W. Schmidt und O. Feustel, Optoelektronik, Vogelverlag, Würzburg 1975, Seite 62, ISBN 3-8023-0076-9).

Für eine Verwendung beispielsweise in einem Gerät zur Ueberwachung einer Flamme sind diese Photodetektoren ungeeignet. Es wird ein selektiver und daher teurer Filter benötigt, der das langwelligere Licht vom Detektor fernhält, das von erhitzten Oberflächen abgestrahlt wird.

Aus "Concepts of Classical Optics" von John Strong, 1958, ISBN: 0 7167 0301 7, sind Interferenzfilter für die Reflexion von ultravioletter Strahlung bekannt.

Der Erfindung liegt die Aufgabe zugrunde, einen Photodetektor aus einem Halbleitermaterial zu schaffen, der im Bereich der Wellenlängen von 200 nm bis 400 nm eine höhere Empfindlichkeit aufweist als im Spektralbereich über 400 nm.

Die Erfindung besteht in den im Kennzeichen des Anspruchs 1 angegebenen Merkmalen.

Ueberlegungen zum Stand der Technik zeigen, dass wegen der unterschiedlichen Eindringtiefe der Strahlung im Halbleiter ein um Grössenordnungen kleineres Detektorvolumen für das Registrieren des kurzwelligeren Teils der Strahlung ausgenutzt wird als für das langwelligere Licht. Obwohl die kurzwelligere Strahlung eine höhere Ausbeute für die Erzeugung von Ladungsträgern aufweist als die langwelligere, werden daher bei gleicher Intensität im Gesamtvolumen des Photodetektors für langwelligeres Licht wesentlich mehr Ladungsträger erzeugt als für ein kurzwelligeres.

Die erfindungsgemässe Begrenzung der Tiefe eines wirksamen Detektorvolumens für die Erzeugung von Ladungsträgern durch Licht aller Wellenlängen erfolgt mittels einer zusätzlichen, in einem speziellen Fabrikationsschritt im Halbleiter eingebauten Potentialschwelle für die Ladungsträger aus dem Substrat. Die Tiefe entspricht der Eindringtiefe der kurzwelligeren Strahlung. Daher beseitigt die Potentialschwelle alle Nachteile der bisher bekannten, aus Halbleitermaterial gefertigten UV-empfindlichen Photodetektoren. Die Erzeugung der Strukturen in Halbleitermaterial und die Vorrichtungen dazu sind an sich bekannt.

Nachstehend werden einige Ausführungsbeispiele der Erfindung anhand der Zeichnungen beschrieben.

Es Zeigen:

Figur 1: Einen schematischen Querschnitt durch eine Diode als Photodetektor mit Schottkykontakt aus einem n-leitenden Halbleiter,

Figur 2: eine schematische Darstellung der Konzentration n der Fremdatome im Photodetektor nach der Figur 1,

Figur 3: eine schematische Darstellung der elektronischen Bandstruktur im Photodetektor nach der Figur 1,

Figur 4: den Photodetektor mit einem pn-Uebergang,

Figur 5: einen schematischen Querschnitt durch eine Diode als Photodetektor mit Schottkykontakt aus einem p-leitenden Halbleiter,

Figur 6: einen schematischen Querschnitt durch einen n-Kanal MOS-Kondensator als Photodetektor,

Figur 7: eine schematische Darstellung der elektronischen Bandstruktur in einem Photodetektor nach der Figur 6,

Figur 8: einen schematischen Querschnitt durch einen n-Kanal MOS-Widerstand als Photodetektor,

Figur 9: einen Querschnitt durch die Photodiode,

Figur 10: eine schematische Darstellung der Konzentration n der Fremdatome in der Photodiode nach der Figur 9 und

Figur 11: die Bandstruktur einer Photodiode nach der Figur 9.

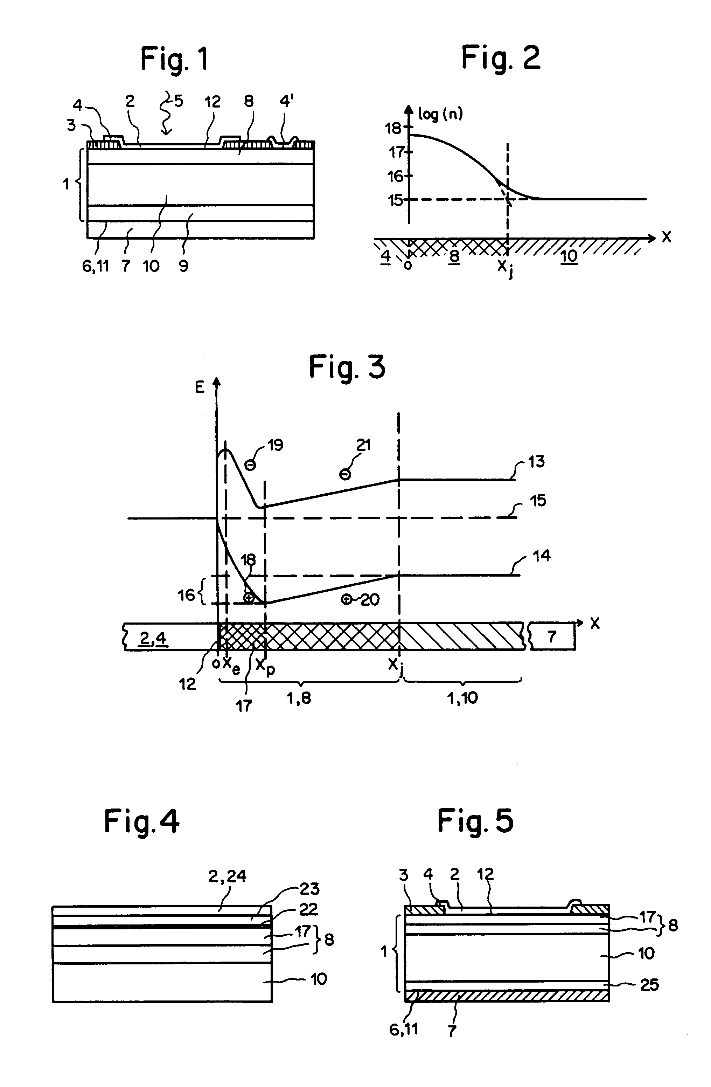

Die Figur 1 zeigt eine erfindungsgemässe Ausführung eines im ultravioletten Spektralbereich empfindlichen Photodetektors. Der Photodetektor weist eine Grundstruktur einer Diode auf und besteht aus einer Folge verschiedener in einem Substrat 1 aus einem n-leitenden Halbleiter durch Dotieren erzeugter Schichten. Auf der Vorderseite des Substrates 1 ist mindestens ein Eintrittsfenster 2 in eine isolierende Deckschicht 3 eingelassen. Das Eintrittsfenster 2 ist mit einer Elektrode 4 bedeckt, die für elektromagnetische Strahlung 5 durchlässig ist. Die durch die Elektrode 4 in den Halbleiter eindringende Strahlung 5 erzeugt bei Absorption mindestens ein Paar Ladungsträger. Die Elektrode 4 und ein auf der Rückseite 6 des Substrates 1 aufgebrachter Anschluss 7 sammeln durch die Strahlung 5 erzeugten Ladungsträger und leiten sie zu einer hier nicht gezeigten Auswertestelle.

Die der Elektrode 4 zugewandte Seite des Substrats 1 ist in Richtung von der Elektrode 4 weg in abnehmender Konzentration dotiert und bildet eine $n^+$- Schicht 8. Die Rückseite 6 weist eine stark dotierte $n^{++}$- Schicht 9 auf. Zwischen den Schichten 8 und 9 befindet sich eine Zwischenschicht 10 aus unverändertem, n-leitendem Material des Substrats 1.

Der Photodetektor nach der Figur 1 wird vorteilhaft auf der Basis des leicht erhältlichen und billigen Siliziums hergestellt. In dieser Technik bekannte Verfahren zur Erzeugung der verschiedenen Schichten sind mit Ausnahme der mit abnehmender Konzentration dotierten Schichten in "Choosing and Using CMOS" von I. Walsh (Collins Professional and Technical Books, London, ISBN 0-00-383042-X) beschrieben.

Eine als Wafer bezeichnete, etwa 0,3 mm dicke, polierte Scheibe eines n-leitenden Siliziumeinkristalls, wie sie in der Halbleiterindustrie üblich ist, dient als das Substrat 1.

Ein Verfahren zur Herstellung des beschriebenen Photodetektors beginnt mit einer starken Dotierung der Rückseite 6 mittels eines üblichen Elemente der V. Hauptgruppe des Periodensystems, z. B. Phosphor. Die so erzeugte $n^{++}$- Schicht 9 ermöglicht einen ohmschen Kontakt 11 zu einer anschliessend auf der Rückseite 6 aufgedampften Metallschicht (z. B. Aluminium) als Anschluss 7.

Anschliessend wird in einem zusätzlichen Fabrikationsschritt die Vorderseite des Substrates 1 mittels Ionenimplantation ein Element der V. Hauptgruppe des Periodensystems, z. B. Phosphor, mit einer Dosis von etwa $10^{13}$cm$^{-2}$ an der Oberfläche leicht dotiert. Ein anschliessender Annealing-Prozess, z. B. bei 1000°C während etwa 30 Min. in einer Stickstoffatmosphäre, lässt allfällige, durch die Implantation entstandene Defekte im Kristallbau ausheilen und den Dotierungsbereich kontrolliert in die Tiefe des Substrats 1 ausdehnen, wodurch sich die erfindungsgemässe, in die Tiefe in abnehmender Konzentration dotierte $n^+$- Schicht 8 bildet.

Die Vorderseite des Substrates 1 wird an der Oberfläche passiviert. Vorteilhaft besteht die etwa 500 nm dicke isolierende Deckschicht 3 aus Siliziumdioxid. Mittels photolithographischer Verfahren wird in die Deckschicht 3 mindestens ein Eintrittsfenster 2 für die Strahlung 5 ausgeschnitten. Schliesslich wird die für die Strahlung 5 durchsichtige Elektrode 4 abgeschieden, z. B. aufgedampft. Die Elektrode 4 bildet zusammen mit dem Substrat 1 bzw. der Schicht 8 einen Schottky-Kontakt 12. Die Elektrode 4 besteht aus einem Metall (vorteilhaft Silber oder Gold) oder einem Metall-Silizid (z. B. Platinsilizid) in einer Stärke von 5 nm bis 10 nm. Auch ein elektrisch leitendes Metalloxid (vorteilhaft des Zinns, des Indiums oder ein Mischoxid aus beiden) in einer Dicke bis zu 500 nm eignet sich für die Elektrode 4. Bei grossflächigen Eintrittsfenstern 2 wird die Leitfähigkeit der Elektrode 4 vorteilhaft mittels eines gitterförmigen Leiters verstärkt.

In einer anderen Ausführung kann das Eintrittsfenster 2 anstelle der Elektrode 4 eine nichtleitende Oxidschicht aufweisen, die beispielsweise die Reflexion des kurzwelligeren Teils der Strahlung 5 herabsetzt. Eine Hilfselektrode 4', die beispielsweise das Fenster ringförmig umschliesst, kontaktiert durch zusätzliche Fenster die $n^+$- Schicht 8.

Die Konzentration $n$ der Fremdatome im Kristall des Photodetektors weist einen in der Figur 2 gezeigten Verlauf als Funktion des Abstandes $x$ von der Oberfläche des Substrates 1 auf. Der Logarithmus zur Basis 10 der Werte $n$ ist auf der Ordinate aufgetragen. Unterhalb der Abszisse sind die entsprechenden Schichten der Diode mittels Schraffuren angedeutet. Die Konzentration $n$ in der Schicht 8 liegt unmittelbar an der Oberfläche des Substrates 1 zwischen $10^{17} cm^{-3}$ und $10^{18} cm^{-3}$ und sinkt bis zu einer Tiefe $x_j$ von etwa 500 nm auf einen durch die Leitfähigkeit des Substrates 1 bestimmten Wert von etwa $10^{15} cm^{-3}$ in der Zwischenschicht 10 ab.

Diese Verteilung der Fremdatome im Kristall bewirkt eine Deformation der elektronischen Bandstruktur, wie dies die Figur 3 zeigt. Das Potential der unteren Kante 13 des Leitungsbandes und der oberen Kante 14 des Valenzbandes sind im Bereich der $n^+$-Schicht 8 und der Zwischenschicht 10 als Funktion des Abstandes $x$ von der Oberfläche des Substrates 1 dargestellt. Unterhalb der Abszisse sind die entsprechenden Schichten der Diode mittels Schraffuren angedeutet. Die Elektrode 4 bestimmt das Niveau der Fermi-Energie 15. Das Potential der oberen Kante 14 des Valenzbandes fällt in die Tiefe vom Wert der Fermi-Energie 15 ab bis zu einem in einer Tiefe von $x_p$ von etwa 50 nm bis 200 nm liegenden, ausgeprägten Minimum und steigt bis in eine Tiefe von $x_j$ um eine Potentialschwelle 16 von etwa 0,1 eV auf das für die Zwischenschicht 10 typische Potential an. Die Potentialschwelle 16 in der Bandkante 14 begrenzt ein Detektorvolumen 17. Daher kann ein Loch 18, das von einem im Detektorvolumen 17 erzeugten Ladungsträgerpaar stammt, nur zur Elektrode 4 wandern und wird dort mit einem Elektron aus deren Leitungsband aufgefüllt. Die untere Bandkante 13 des Leitungsbandes weist wegen der metallischen Elektrode 4 ein Maximum in einer geringen Tiefe von $x_e$ von einigen Nanometern unter der Elektrode 4 auf. Dieses Maximum zwingt ein Elektron 19, das mit dem Loch 18 erzeugt worden ist, aus dem Detektorvolumen 17 zum Anschluss 7 zu wandern. Dadurch entsteht eine EMK, die als ein Ausgangssignal zum Nachweis der Strahlung 5 herangezogen werden kann.

Die bis in eine Tiefe von $x_e$ erzeugten Ladungsträgerpaare fliessen zur Elektrode 4 und rekombinieren dort, ohne zum Ausgangssignal etwas beizutragen.

Der langwelligere Teil der Strahlung 5 erzeugt auch ausserhalb des Detektorvolumens 17 in den Schichten 8 und 10 Ladungsträger, z. B. ein Loch 20 und ein Elektron 21. Sie können wegen der Potentialschwelle 16 nur in Richtung des Anschlusses 7 wandern. Dort rekombinieren das Loch 20 und das Elektron 21 und tragen ebenfalls nichts zur EMK bei.

Diese Potentialschwelle 16 bildet eine wirksame Begrenzung des Detektorvolumens 17. Der kurzwelligere Teil der Strahlung 5 wird fast vollständig im Detektorvolumen 17 absorbiert, von der langwelligeren Strahlung 5 hingegen erzeugt nur ein kleiner Teil im Detektorvolumen 17 zur EMK beitragende Ladungsträger. Die Wahl der Parameter bei der Ionenimplantation und im Annealing-Prozess sowie die Art der Fremdatome bestimmen die Lage der Potentialschwelle 16 im Photodetektor und damit dessen spektrale Empfindlichkeit.

In einer anderen Ausführung der Erfindung ist der SchottkyKontakt 12 durch einen pn-Uebergang 22 (Figur 4) ersetzt. Eine nur 10 nm bis 30 nm dicke, möglichst gleichmässig stark dotierte $p^{++}$- Schicht 23 bildet unmittelbar an der Substratoberfläche im Bereich des Eintrittsfensters 2 mit der $n^+$- Schicht 8 den pn-Uebergang 22. Die $p^{++}$-Schicht 23 kontaktiert das Detektorvolumen 17 besser, falls anstelle der Elektrode 4 (Figur 1) im Eintrittsfenster 2 (Figur 4) nur ein isolierender Antireflexionsbelag 24 vorhanden ist.

Die Herstellung des pn-Uebergangs 22 erfolgt nach dem Annealing-Prozess. Mittels Implantierung von Fremdionen eines Elementes der III. Hauptgruppe des Periodensystems, beispielsweise Bor, in einer Konzentration im Bereich von $10^{19} cm^{-3}$ bis $10^{20} cm^{-3}$ wird nahe der Oberfläche die $n^+$-Schicht 8 in eine $p^{++}$-Schicht 23 umdotiert.

Eine andere Ausführung des Photodetektors benutzt ein Substrat 1 aus p-leitendem Material (Figur 5). Das Substrat 1 erhält auf der Rückseite 6 in an sich bekannter Weise mit Aluminium einen ohmschen Kontakt 11. Es bildet sich dabei unter der Aluminiumschicht durch Diffusion eine $p^+$-Schicht 25. Die Aluminiumschicht dient als Anschluss 7. Auf der Vorderseite des Substrates 1 wird mit dem bisher beschriebenen Verfahren das Detektorvolumen 17 mittels der unter dem Eintrittsfenster 2 eingebauten $n^+$-Schicht 8 begrenzt und auf der $n^+$-Schicht 8 mittels der Elektrode 4 ein Schottky-Kontakt 12 erzeugt. Die Potentialschwelle 16 (Figur 3) ist mit über 0,3 eV wesentlich höher als die in einem n-leitenden Substrat 1 erreichbare, da die Bandkanten 13 und 14 relativ zur Fermi-Energie 15 in der Zwischenschicht 10 (Figur 5) höher liegen.

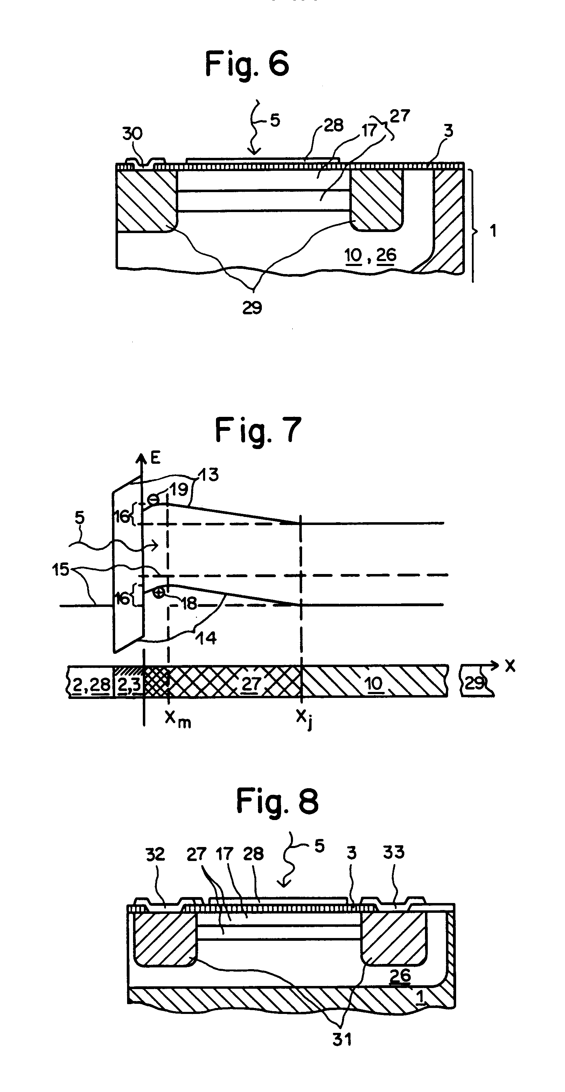

Beispielsweise kann vorteilhaft anstelle eines p-leitenden Substrats 1 ein p-letendes, in einem n-leitenden Substrat 1 eingebautes Gebiet 26 (Figur 6) benutzt werden oder anstelle eines n-leitenden Substrats 1 ein n-leitendes, in einem p-leitenden Substrat 1 eingebautes Gebiet 26 benützt werden.

Eine andere vorteilhafte Ausführung der Erfindung sind Photodetektoren, die eine MOS-Struktur aufweisen.

Die Figur 6 zeigt einen n-Kanal MOS-Kondensator auf dem annähernd homogen dotierten p-leitenden Substrat 1. Das p-leitende Gebiet 26 weist an der Oberfläche eine leicht dotierte $p^+$-Schicht 27 auf, deren Konzentration der Fremdatome von etwa $10^{17} cm^{-3}$ an der Oberfläche bis auf $10^{15} cm^{-3}$ der Zwischenschicht 10 abnimmt. Die Vorderseite des Substrates 1 ist mit der isolierenden, für die Strahlung 5 durchsichtige Deckschicht 3 aus Siliziumdioxid von 50 nm und mit dem darüber angeordetenden, durchsichtigen, metallisch leitenden Gate 28 abgedeckt. Das Detektorvolumen 17 wird einerseits über die Zwischenschicht 10 mittels des rückseitig aufgebrachten Anschlusses 7 wie in der Figur 5 oder von der Vorderseite her mittels eines stark dotierten $p^{++}$-Kontaktes 29 (Figur 6) durch ein Fenster 30 in der Deckschicht 3 kontaktiert. Das hier nicht gezeigte externe Auswertegerät misst als ein Ausgangssignal die Kapazität des MOS-Kondensators zwischen dem Gate 28 und dem Anschluss 7 bzw. dem $p^{++}$-Kontakt 29. Der $p^{++}$-Kontakt 29 umfasst vorteilhaft die $p^+$-Schicht 27 ringförmig.

Das Gate 28 und die Deckschicht 3 werden vorteilhaft als Antireflexionsbelag für den kurzwelligeren Teil der Strahlung 5 ausgeführt. Die Figur 7 zeigt in einer schematischen Darstellung die elektronische Struktur im Kristall bei einer Ausführung gemäss der Figur 6. Die Fermi-Energie 15 (Figur 7) und die Energie der Bandkanten 13 und 14 sind als Funktion des Abstandes x von der Oberfläche des Substrates 1 dargestellt. Unterhalb der Abszisse sind die entsprechenden Schichten der n-Kanal MOS-Struktur mittels Schraffuren angedeutet. Die Potentiale beider Bandkanten 13 und 14 steigen von der Deckschicht 3 weg bis zu einem Maximum in einer Tiefe von $x_m$ von etwa 50 nm bis 200 nm an und fallen dann infolge der mit abnehmender Konzentration der Fremdatome dotierten $p^+$-Schicht 27 auf die Werte der Zwischenschicht 10 in der Tiefe $x_j$ von 200 nm bis 500 nm ab. Die $p^+$-Schicht 27 enthält daher die Potentialschwellen 16. Auch in dieser Anordnung begrenzen die Potentialschwellen 16 das Detektorvolumen 17 in einer Tiefe von $x_m$.

Von Ladungsträgerpaaren, die in einer Tiefe bis zu $x_m$ erzeugt wurden, wandert das Elektron 19 unmittelbar unter die Deckschicht 3. Das Loch 18 ist unter der Potentialschwelle 16 gefangen. Diese getrennten, von der Strahlung 5 erzeugten Ladungsträgerpaare erhöhen die Kapazität des n-Kanal MOS-Kondensators. Die in einer Tiefe von mehr als $x_m$ erzeugten Ladungsträger rekombinieren über den $p^{++}$-Kontakt 29 und tragen zu einer Erhöhung der Kapazität nichts bei.

Mittels eines negativen Impulses auf das Gate 28 wird der MOS-Kondensator periodisch entleert, falls eine Dosisleistung der Strahlung 5 zu messen ist.

Eine andere vorteilhafte Ausführung der Erfindung ergibt einen n-Kanal MOS-Photowiderstand (Figur 8). Die das begrenzte Detektorvolumen 17 enthaltende, flache $p^+$-Schicht 27 ist im p-leitenden Gebiet 26 des Substrates 1 eingelassen und beispielsweise quaderförmig ausgebildet. Zwei einander gegenüberliegende Seitenflächen der $p^+$-Schicht 27 sind mit je einem Balken 31 aus $n^+$-Material kontaktiert. Die Balken 31 reichen von der Oberfläche des Substrates her tiefer in das Gebiet 26 ein als die $p^+$-Schicht 27. Die beiden Balken 31 sind durch das Detektorvolumen 17 miteinander elektrisch verbunden. Die eindringende Strahlung 5 erzeugt unter dem durch eine Deckschicht 3 aus Siliziumdioxid vom Substrat 1 getrennten Gate 28 eine von ihrer Intensität abhängige Ladungsträgerdichte und verändert daher den elektrischen Widerstand zwischen den beiden Balken 31. Die Balken 31 sind durch Fenster in der Deckschicht 3 mit einer Sourceleitung 32 und einer Drainleitung 33 kontaktiert.

Der n-Kanal MOS-Photowiderstand ist auch als ein Transistor betreibbar, falls das Potential des Gates 28 steuerbar ist.

Die verschiedenen Dotierungen werden vorzugsweise mittels Ionenimplantation eines Elementes der III. Hauptgruppe des Periodensystems erzeugt, wobei für die erfindungsgemäss dotierte $p^+$-Schicht 27 der Annealing-Prozess ebenfalls vorteilhaft ist.

Anstelle der n-Kanal MOS-Photodetektoren sind auch Ausführungen der Erfindung mit p-Kanal MOS-Strukturen herstellbar. In den obigen Beschreibungen sind die Bezeichnungen "p" und "n" sowie "Loch" und "Elektron" zu vertauschen, wobei die n-Schichten mittels Dotieren mit einem Element der IV. Hauptgruppe des Periodensystems erzeugt werden.

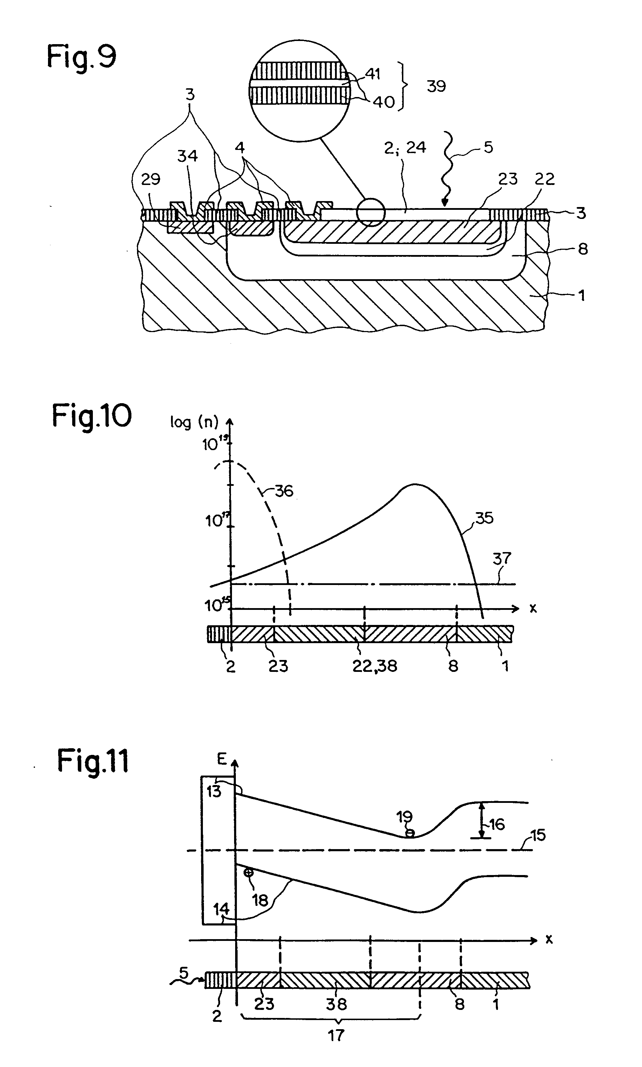

In einer anderen Ausführung nach der Figur 9 werden die Detektionsverluste von kurzwelligem, ultraviolettem Licht wirksam verkleinert, sowie die Detektionsverluste von sichtbarem und infrarotem Licht vergrössert und damit die Empfindlichkeit sowie die Selektivität des Photodetektors für ultraviolettes Licht gesteigert. Das Eintrittsfenster 2 mit dem Antireflexionsbelag 24 und die Deckschicht 3 über dem Substrat 1 sowie die unter dem Eintrittsfenster 2 liegenden, wannenförmig ausgebildeten Schichten, die $p^{++}$-Schicht 23, die $n^+$-Schicht 8, dem pn-Uebergang 22 zwischen den beiden Schichten 8, 23 und das p-leitende Substrat 1 sind erkennbar. Das Substrat 1 wird mittels des $p^{++}$-Kontaktes 29, die $n^+$-Schicht 8 mittels einer $n^{++}$-Insel 34 und die $p^{++}$-Schicht 23 direkt von metallischen Elektroden 4 kontaktiert.

Die Herstellung der Photodiode nach der Figur 9 beginnt mit der Erzeugung einer beispielsweise 30 nm dicken $SiO_2$-Schicht auf dem p-leitenden Substrat 1 aus einer Scheibe eines Siliziumeinkristalls durch Oxidieren der Kristalloberfläche. Das Substrat 1 weist typisch eine Konzentration der Fremdatome im Kristall zwischen $10^{14}$ $cm^{-3}$ und $10^{16}$ $cm^{-3}$ auf. Diese $SiO_2$-Schicht bildet einen Teil der Deckschicht 3 bzw. des Eintrittsfensters 2. Anschliessend werden gezielt vorbestimmte Mengen von Fremdatomen durch die $SiO_2$-Schicht hindurch in das Gitter des Halbleiters in vorbestimmte Tiefen als Ionen implantiert.

Die $n^+$-Schicht 8 wird durch eine Implantation von Phosphorionen von vorbestimmter Energie erzeugt, wobei die Reichweite der Ionen von deren Energie abhängt. Beträgt die Ionenenergie beispielsweise 100 keV, tritt eine maximale Konzentration der Phosphoratome, typisch etwa $10^{18}$ $cm^{-3}$, in einer Tiefe von 100 nm unter der Oberfläche auf.

Die Figur 10 zeigt die Fremdatomkonzentrationen n in $cm^{-3}$ in logarithmischer Darstellung als Funktion des Abstandes x von der Oberfläche. Unterhalb der Abszisse ist ein schematischer Querschnitt durch den Photodetektor im gleichen Massstab gezeichnet. Eine ausgezogene Linie 35 zeigt den typischen Verlauf der Phosphorkonzentration.

Die hohe Konzentration des Phosphors an der Oberfläche der $n^{++}$-Insel 34 wird mittels Phosphorionen vorbestimmter, geringerer Energie, beispielsweise zwischen 10 keV und 20 keV, erzeugt. In die $n^+$-Schicht 8 dringen diese Ionen etwa 15 nm ein, wobei das Maximum der Konzentration an der Grenze zwischen der Deckschicht 3 und dem Halbleiterkristall liegt.

Eine Implantation von Borionen von vorbestimmter Energie erzeugt die $p^{++}$-Schicht 23 und den $p^{++}$-Kontakt 29. Werden Borionen vom 8 keV bis 12 keV verwendet, tritt das Maximum der Konzentration an der Grenze zwischen dem Eintrittsfenster 2 bzw. der Deckschicht 3 und dem Halbleiterkristall auf. Die Dicke der $p^{++}$-Schicht 23 und des $p^{++}$-Kontaktes 29 beträgt etwa 15 nm bis 30 nm. Eine maximale Konzentration von $10^{-18}$ $cm^{-3}$ bis $10^{19}$ $cm^{-3}$ ist vorteilhaft. Das bevorzugte Konzentrationsprofil der Boratome ist mittels einer gestrichelten Linie 36 eingetragen.

Die Fremdatomkonzentration des Substrates 1 deutet eine strichpunktierte Linie 37 an.

Das schnelle Abfallen der Borkonzentration unterhalb der $p^{++}$-Schicht 23 auf etwa $10^{16}$ $cm^{-3}$ in etwa 30 nm Tiefe und das langsame Ansteigen der Phosphorkonzentration in grösserer Tiefe bewirkt eine Trennung der $p^{++}$-Schicht 23 und der $n^+$-Schicht 8 durch ein 30 nm bis 60 nm breites Gebiet 38 mit dem pn-Uebergang 22. Da die Fremdatomkonzentration weniger als $10^{17}$ $cm^{-3}$ beträgt, ist das Gebiet quasi-intrinsisch leitend. Daher gleicht in dieser Ausführung der Aufbau der Photodiode der einer PIN-Diode.

Der anschliessende Annealingprozess dient zum Einbau der implantierten Ionen in das Gitter des Halbleiterkristalls (elektrische Aktivierung), wobei das Substrat 1 mehrmals nur für sehr kurze Zeit, beispielsweise 1 bis 3 Sekunden, auf eine Temperatur von > 900°C erwärmt wird, um eine Diffusion der Fremdatome zu vermeiden.

Die Figur 11 zeigt die Energie der unteren Bandkante 13 des Leitungsbandes und der oberen Bandkante 14 des Valenzbandes im Halbleiterkristall als Funktion des Abstandes x von der Oberfläche. Mit der Bezugszahl 15 ist die FERMI-Energie bezeichnet. Unter der Abszisse ist ein Querschnitt durch den Photodetektor im gleichen Massstab dargestellt.

Die erfindungsgemässen Konzentrationsprofile erzeugen im Kristall Bandkanten 13,14, deren Verlauf in die Tiefe des Substrates 1 vom Eintrittsfenster 2 bis zu einem Minimum des Energiewerts in der $n^+$-Schicht 8 fallend ist, um erst nach dem Ueberschreiten des Maximums der Borkonzentration wieder auf die Niveaux im p-leitenden Substrat 1 anzusteigen. Dieser Anstieg erzeugt die für die Begrenzung des wirksamen Detektorvolumens 17 notwendige Potentialschwelle 16. Da das Energiemaximum der Bandkanten 13,14 unmittelbar an der Grenzschicht zwischen dem Eintrittsfenster 2 und der $p^{++}$-Schicht 23 auftritt, vermeidet dieser Aufbau der Photodiode eine Strahlung 5 absorbierende, tote Zone unter dem Eintrittsfenster 2. Dies erhöht die Empfindlichkeit des Photodetektors vorteilhaft, welche für ultraviolettes Licht praktisch 100% erreicht.

Das wirksame Detektorvolumen 17 erstreckt sich vom Eintrittsfenster 2 bis zum Minimum in der $n^+$-Schicht 8. Die im Detektorvolumen 17 von der vornehmlich kurzwelligeren Strahlung 5 erzeugten Ladungsträgerpaare werden getrennt, wobei sich wegen der Potentialschwelle 16 die Elektronen 19 im Energieminimum der unteren Bandkante 13 in der $n^+$-Schicht 8 und die Löcher 18 unter dem Eintrittsfenster 2 in der $p^{++}$-Schicht 23 sammeln, wobei eine EMK von etwa 0,1 V auftritt.

Die langwelligere Strahlung dringt tiefer als 100 nm in das Substrat 1 ein. Sie erzeugt auch ausserhalb des Detektorvolumens 17 im Substrat 1 Ladungsträgerpaare, die nicht getrennt werden, die im Substrat 1 wieder rekombinieren und die daher keinen Beitrag zum Ausgangssignal liefern.

Die Empfindlichkeit und die Selektivität des Photodetektors für kurzwelligere Strahlung kann durch den z. B in der Figur 9 als ein Interferenzfilter 39 wirksamen Antireflexionsbelag 24 verbessert werden. Das Interferenzfilter 39 ist aus dünnen Schichten aufgebaut, wobei sich Oxidschichten 40 und Metallschichten 41 abwechseln. In einem vergrössert dargestellten Ausschnitt ist beispielhaft eine Ausführung des Interferenzfilters 39 mit zwei Oxidschichten 40 aus $SiO_2$ und mit einer dazwischen eingebetteten Metallschicht 41 gezeigt. Der Interferenzfilter 39 ist für eine Strahlung mit einer Wellenlänge von 300 nm transparent, schwächt aber eine Strahlung 5 mit längeren Wellenlängen wirksam ab.

Die bei der Implantation benötigte Deckschicht 3 von 30 nm wird zunächst mittels Aufdampfen auf eine Dicke von 50 nm erhöht. Anschliessend wird die Oberfläche der ersten Oxidschicht 40 mit einer Metallschicht 41 zumindest im Bereich des Eintrittsfensters 2 über der $p^{++}$-Schicht 23 bedampft. Vorteilhaft ist die Schicht 41 aus Aluminium und 10 nm dick. Ueber dieser Metallschicht 41 folgt wiederum eine 50 nm dicke $SiO_2$-Schicht, d. h. eine Oxidschicht 40. Eine grössere Selektivität des Interferenzfilters 39 wird durch eine grössere Anzahl dieser Schichten 40, 41 erreicht.

In der Ausführung nach der Figur 9 ist für das Eintrittsfenster 2 eine Fläche von 1 $mm^2$ vorteilhaft, jedoch ist die Grösse nur durch die Fläche des verfügbaren Substrats 1 begrenzt.

Auf einem Wafer sind mehrere Photodetektoren gleichzeitig herstellbar, die allfällig noch direkt mit zusätzlichen Elementen einer integrierten Schaltung verbunden sind. Die Anzahl ist lediglich durch den Flächenbedarf der einzelnen Schaltung begrenzt. Der Platzbedarf von zuverlässig arbeitenden Photodetektoren auf dem Substrat 1 ist klein, solche mit Abmessungen von 0,4 mm x 0,4 mm sind herstellbar.

**Patentansprüche**

1. Photodetektor insbesondere für UV, mit einem in einer Halbleiterstruktur eingebetteten Detektorvolumen (17) zum Nachweis einer durch ein Eintrittsfenster (2) hindurch in das Detektorvolumen (17) eindringenden elektromagnetischen Strahlung (5),
dadurch gekennzeichnet,
dass eine unter dem Eintrittsfenster (2) gelegene Schicht (8; 27) in einem Substrat (1) mittels Fremdatomen von einer sich mit der Tiefe (x) ändernden Konzentration dotiert ist,
dass die elektronische Bandstruktur der Halbleiterstruktur wegen der Dotierung des Substrats (1) in der Schicht (8; 27) so verzerrt ist, daß sie in einer vorbestimmten Tiefe ($x_p$ bzw. $x_m$) eine Potentialschwelle (16) für die Minoritätsträger von mindestens 0,1 eV Höhe aufweist, die das Detektorvolumen (17) unter dem Eintrittsfenster (2) in der vorbestimmten Tiefe bei einem Wert ($x_p$ bzw. $x_m$) zwischen 50 nm und 200 nm begrenzt, und
dass nur im Detektorvolumen (17) von der Strahlung (5) erzeugte Ladungsträger zu einem Ausgangssignal des Photodetektors beitragen.

2. Photodetektor nach Anspruch 1, dadurch gekennzeichnet, dass die Schicht (8; 27) auf der vom Eintrittsfenster (2) abgewandten Seite an eine Zwischenschicht (10; 26) grenzt und dass in der Schicht (8; 27) die Konzentration der Fremdatome an der Oberfläche des Substrats (1) Werte von $10^{17}\,cm^{-3}$ bis $10^{18}\,cm^{-3}$ erreicht und bis zur Grenze an der Zwischenschicht (10; 26) auf den Wert des undotierten Substrats (1) absinkt.

3. Photodetektor nach Anspruch 1 oder 2, dadurch gekennzeichnet, dass das Substrat (1) in der Schicht (8) mit Fremdatomen $n^+$-leitend dotiert ist, dass die Halbleiterstruktur die Struktur einer Schottky-Diode aufweist und dass eine Elektrode (4; 4') im Bereich des Eintrittsfensters (2) mit dem Detektorvolumen (17) einen Schottky-Kontakt (12) bildet.

4. Photodetektor nach Anspruch 1 oder 2, dadurch gekennzeichnet, dass das Substrat (1) in der Schicht (8) mit Fremdatomen $n^+$-leitend dotiert ist, dass die Halbleiterstruktur die Struktur eines PN-Uebergangs (22) aufweist und dass zwischen dem Eintrittsfenster (2) und dem Detektorvolumen (17) eine stark dotierte $p^{++}$-Schicht (23) angeordnet ist, die mit der Schicht (8) den PN-Uebergang (22) bildet.

5. Photodetektor nach Anspruch 1, dadurch gekennzeichnet, dass dass die Halbleiterstruktur die Struktur einer PIN-Diode aufweist, dass unmittelbar unter dem Eintrittsfenster (2) eine stark dotierte $p^{++}$-Schicht (23) angeordnet ist, wobei zwischen der $p^{++}$-Schicht (23) und dem Detektorvolumen (17) ein PN-Uebergang (22) entsteht, dass die Konzentration der Fremdatome zum Erzeugen der Schicht (8) in das p-leitenden Substrat (1) eingebrachte $n^+$-Dotierung am PN-Uebergang (22) weniger als $10^{17}\,cm^{-3}$ beträgt und ein Maximum von etwa $10^{18}\,cm^{-3}$ im Bereich der Potentialschwelle (16) erreicht, wobei ein quasi-intrinsisch leitendes Gebiet (38) eine Trennung der $p^{++}$-Schicht

(23) und der $n^+$-Schicht (8) bewirkt, und dass das quasi-intrinsisch leitende Gebiet (38) eine Dicke von 30 nm bis 60 nm aufweist.

6. Photodetektor nach Anspruch 1 oder 2, dadurch gekennzeichnet, dass die Halbleiterstruktur eine MOS-Struktur ist, dass die $n^+$-leitende (8) bzw. die $p^+$-leitende (27) Schicht direkt unterhalb eines für die Strahlung (5) durchlässigen, vom Substrat (1) mittels einer Deckschicht (3) isolierten metallisch leitenden Gates (28) angeordnet ist und dass das Detektorvolumen (17) den $p^+$- bzw. $n^+$-Leitungskanal der MOS-Struktur bildet.

7. Photodetektor nach Anspruch 6, dadurch gekennzeichnet, dass die $n^+$- bzw. $p^+$-leitende Schicht (27) mittels eines metallisch leitenden $n^{++}$- bzw. $p^{++}$- Kontaktes seitlich begrenzt ist, wobei das Detektorvolumen (17) das Dielektrikum eines durch die MOS-Struktur gebildeten Kondensators ist, dessen Kapazität des Kondensators von im Detektorvolumen (17) von der Strahlung (5) gebildeten Lagungsträger abhängig ist.

8. Photodetektor nach Anspruch 6, dadurch gekennzeichnet, dass die MOS-Struktur zwei $p^+$- bzw. $n^+$-leitende Balken aufweist, von denen der eine mit einer Sourceleitung (32) und der andere mit einer Drainleitung (33) kontaktiert ist, dass sich die $n^+$- bzw. $p^+$-leitende Schicht (27) zwischen zwei $p^+$- bzw. $n^+$-leitenden Balken (31) erstreckt und dass das Detektorvolumen (17) einen von der Intensität der Strahlung (5) abhängigen elektrischen Widerstand zwischen den beiden Balken (31) bildet.

9. Photodetektor nach einem der Ansprüche 1 bis 8, dadurch gekennzeichnet, dass das Eintrittsfenster (2) mit einer Antireflexionsschicht (24) beschichtet ist.

10. Photodetektor nach einem der Ansprüche 1 bis 8, dadurch gekennzeichnet, dass das Eintrittsfenster (2) mit einem Interferenzfilter (39) bedeckt ist, das für eine Strahlung (5) mit einer Wellenlänge von 300 nm transparent ist und langwelligere Strahlung (5) wirksam abschirmt.

11. Photodetektor nach einem der Ansprüche 1 bis 9, dadurch gekennzeichnet, dass das Substrat (1) aus Silizium ist.

12. Verfahren zum Herstellen eines Photodetektors nach Anspruch 1 oder 2, dadurch gekennzeichnet, dass vor dem Erzeugen einer Deckschicht (3) die Vorderseite des Substrates (1) im Bereich des Eintrittsfensters (2) mittels Ionenimplantierung mit Fremdatomen bis zu einer Dosis von ungefähr $10^{13} cm^{-2}$ dotiert wird und dass mittels eines Annealing-Prozesses bei 1000°C während etwa 30 Minuten die Fremdatome kontrolliert von der Vorderseite her in das Substrat (1) eindiffundiert werden, bis die Potentialschwelle (16) die vorbestimmte Tiefe ($x_p$ bzw. $x_m$) von 50 nm bis 200 nm erreicht hat.

13. Verfahren nach Anspruch 12, dadurch gekennzeichnet, dass die Vorderseite des Substrates (1) oder eines Gebietes (26), die entweder n- oder p-leitend sind, die freiliegende Schicht (8) $n^+$-leitend dotiert wird, dass anschliessend auf der Vorderseite die isolierende Deckschicht (3) erzeugt wird, dass mittels photolithographischer Verfahren mindestens ein Eintrittsfenster (2) in die Deckschicht (3) geschnitten wird und dass die freiliegende $n^+$-Schicht (8) mittels eines für die Strahlung (5) durchlässigen nichtohmschen Kontaktes (12; 22) zu einem elektrischen Leiter (4; 4'; 23) kontaktiert wird.

14. Verfahren nach Anspruch 12, dadurch gekennzeichnet, dass die Vorderseite des p-leitenden bzw. n-leitenden Substrates (1) oder Gebietes (26) $n^+$-leitend bzw. $p^+$-leitend dotiert wird und dass anschliessend das Detektorvolumen (17) kontaktiert, die Vorderseite mit einer isolierenden Deckschicht (3) bedeckt und im Bereich des Eintrittsfensters (2) ein für die Strahlung (5) durchlässiges, isoliertes Gate (28) erzeugt wird.

15. Verfahren zum Herstellen eines Photodetektors nach Anspruch 5, dadurch gekennzeichnet, dass auf der Vorderseite des p-leitenden Substrates (1) eine im Bereich des Eintrittsfensters (2) für die Strahlung (5) durchlässige Deckschicht (3) erzeugt wird, dass durch die Deckschicht (3) hindurch das Substrat (1) durch Ionen dotiert wird, wobei die Schicht (8) $n^+$-leitend und die Inseln (34) $n^{++}$-leitend und die $p^{++}$-Schicht (23) und die $p^{++}$-Kontakte (29) $p^{++}$-leitend werden, und dass zum Erzeugen der Potentialschwelle (16) in der $n^+$-leitenden Schicht (8) für die Konzentration der Fremdatome ein Maximum in der vorbestimmten Tiefe ($x_p$) erreicht wird.

## Claims

1. A photodetector, in particular for UV, having a detector volume (17) which is embedded in a semiconductor structure for detection of an electromagnetic radiation (5) which penetrates through an entry window (2) into the detector volume (17), characterised in that a layer (8; 27) beneath the entry window (2) in a substrate (1) is doped by means of impurity atoms of a concentration which varies with the depth (x), that the electronic band structure of the semiconductor structure is distorted because of the doping of the substrate (1) in the layer (8; 27) so that at a predetermined depth ($x_p$ or $x_m$) it has a potential barrier (16) for the minority carriers of at least 0.1 eV in height, which delimits the detector volume (17) under the entry window (2) to the predetermined depth at a value ($x_p$ or $x_m$) of between 50 nm and 200 nm, and that only charge carriers generated in the detector volume (17) by the radiation (5) contribute to an output signal of the photodetector.

2.   A photodetector according to claim 1 characterised in that the layer (8; 27), on the side remote from the entry window (2), adjoins an intermediate layer (10; 26) and that in the layer (8; 27) the concentration of the impurity atoms reaches values of $10^{17}$ $cm^{-3}$ to $10^{18}$ $cm^{-3}$ at the surface of the substrate (1) and falls as far as the boundary with the intermediate layer (10; 26) to the value of the undoped substrate (1).

3.   A photodetector according to claim 1 or claim 2 characterised in that the substrate (1) is $n^+$-conductively doped with impurity atoms in the layer (8), that the semiconductor structure has the structure of a Schottky diode and that an electrode (4; 4') in the region of the entry window (2) forms a Schottky contact (12) with the detector volume (17).

4.   A photodetector according to claim 1 or claim 2 characterised in that the substrate (1) is $n^+$-conductively doped with impurity atoms in the layer (8), that the semiconductor structure has the structure of a PN-junction (22) and that arranged between the entry window (2) and the detector volume (17) is a heavily doped $p^{++}$-layer (23) which forms the PN-junction (22) with the layer (8).

5.   A photodetector according to claim 1 characterised in that the semiconductor structure has the structure of a PIN-diode, that arranged immediately under the entry window (2) is a heavily doped $p^{++}$-layer (23), a PN-junction (22) being produced between the $p^{++}$-layer (23) and the detector volume (17), that the concentration of the impurity atoms for producing the layer (8) of the $n^+$-doping introduced into the p-conducting substrate (1), at the PN-junction (22), is less than $10^{17}$ $cm^{-3}$ and reaches a maximum of about $10^{18}$ $cm^{-3}$ in the region of the potential barrier (16), a quasi-intrinsically conducting region (38) providing for separation of the $p^{++}$-layer (23) and the $n^+$-layer (8), and that the quasi-intrinsically conducting region (38) is of a thickness of from 30 nm to 60 nm.

6.   A photodetector according to claim 1 or claim 2 characterised in that the semiconductor structure is an MOS-structure, that the $n^+$-conducting layer (8) or the $p^+$-conducting layer (27) is arranged directly beneath a metallically conducting gate (28) which is transmissive in respect of the radiation (5) and which is insulated from the substrate (1) by means of a cover layer (3) and that the detector volume (17) forms the $p^+$- or $n^+$-conduction channel of the MOS-structure.

7.   A photodetector according to claim 6 characterised in that the $n^+$- or $p^+$-conducting layer (27) is laterally delimited by means of a metallically conducting $n^{++}$- or $p^{++}$-contact, wherein the detector volume (17) is the dielectric of a capacitor which is formed by the MOS-structure and whose capacitance of the capacitor is dependent on charge carriers formed in the detector volume (17) by the radiation (5).

8.   A photodetector according to claim 6 characterised in that the MOS-structure has two $p^+$- or $n^+$-conducting bars of which one is contacted with a source line (32) and the other with a drain line (33), that the $n^+$- or $p^+$-conducting layer (27) extends between two $p^+$- or $n^+$-conducting bars (31) and that the detector volume (17) forms an electrical resistance between the two bars (31), which is dependent on the intensity of the radiation (5).

9.   A photodetector according to one of claims 1 to 8 characterised in that the entry window (2) is coated with an anti-reflection layer (24).

10.   A photodetector according to one of claims 1 to 8 characterised in that the entry window (2) is covered with an interference filter (39) which is transparent in relation to a radiation (5) of a wavelength of 300 nm and which effectively screens longer-wave radiation (5).

11.   A photodetector according to one of claims 1 to 9 characterised in that the substrate (1) is of silicon.

**12.** A process for the production of a photodetector according to claim 1 or claim 2 characterised in that, prior to the production of a cover layer (3), the front side of the substrate (1) is doped in the region of the entry window (2) by means of ion implantation with impurity atoms to a dosage of about $10^{13}$ cm$^{-2}$ and that the impurity atoms are controlledly diffused from the front side into the substrate (1) by means of an annealing procedure at 1000°C for a period of about 30 minutes until the potential barrier (16) has reached the predetermined depth ($x_p$ or $x_m$) of from 50 nm to 200 nm.

**13.** A process according to claim 12 characterised in that on the front side of the substrate (1) or a region (26) which are either n-conducting or conducting, the exposed layer (8) is n$^+$-conductively doped, that then the insulating layer (3) is produced on the front side, that at least one entry window (2) is cut into the cover layer (3) by means of photolithographic processes and that the exposed n$^+$-layer (8) is contacted with an electrical conductor (4; 4'; 23) by means of a non-ohmic contact (12; 22) which is transmissive in respect of the radiation (5).

**14.** A process according to claim 12 characterised in that the front side of the p-conducting or n-conducting substrate (1) or region (26) is n$^+$-conductively or p$^+$-conductively doped and that then the detector volume (17) is contacted, the front side is covered with an insulating cover layer (3) and an insulated gate (28) which is transmissive in respect of the radiation (5) is produced in the region of the entry window (2).

**15.** A process for the production of a photodetector according to claim 5 characterised in that a cover layer (3) which is transmissive in respect of the radiation (5) in the region of the entry window (2) is produced on the front side of the p-conducting substrate (1), that the substrate (1) is doped by ions through the cover layer (3), wherein the layer (8) becomes n$^+$-conducting and the islands (34) become n$^{++}$-conducting and the p$^{++}$-layer (23) and the p$^{++}$-contacts (29) become p$^{++}$-conducting, and that a maximum is achieved at the predetermined depth ($x_p$) to produce the potential barrier (16) in the n$^+$-conducting layer (8) in regard to the concentration of the impurity atoms.

**Revendications**

**1.** Photodétecteur, notamment pour un rayonnement ultraviolet, comportant un volume détecteur (17) incorporé dans une structure de semiconducteur pour signaler un rayonnement électromagnétique (5) pénétrant à travers une fenêtre d'entrée (2) dans le volume détecteur (17), caractérisé en ce qu'une couche (8 ; 27) située en dessous de la fenêtre d'entrée (2) dans un substrat (1) est dopée au moyen d'atomes étrangers d'une concentration variant avec la profondeur (x), en ce que la structure de bande électronique de la structure semiconductrice est déformée sous l'effet du dopage du substrat (1) dans la couche (8 ; 27) de telle sorte qu'elle comporte, à une profondeur prédéterminée ($x_p$ ou $x_m$) un seuil de potentiel (16) d'une grandeur d'au moins 0,1 eV pour les porteurs minoritaires, ce seuil délimitant le volume détecteur (17) en dessous de la fenêtre d'entrée (2) pour une valeur de la profondeur prédéterminée ($x_p$ ou $x_m$) comprise entre 50 nm et 200 nm, et en ce que seulement les porteurs de charge produits dans le volume détecteur (17) par le rayonnement (5) contribuent à la production d'un signal de sortie du photodétecteur.

**2.** Photodétecteur selon la revendication 1, caractérisé en ce que la couche (8 ; 27 ) est délimitée, sur le côté opposé à la fenêtre d'entrée (2), par une couche intermédiaire (10 ; 26) et en ce que, dans la couche (8 ; 27 ), la concentration des atomes étrangers sur la surface du substrat (1) atteint des valeurs de $10^{17}$ cm$^{-3}$ à $10^{18}$ cm$^{-3}$ et décroît jusqu'à la limite à la couche intermédiaire (10 ; 26) à la valeur du substrat non dopé (1).

**3.** Photodétecteur selon la revendication 1 ou 2, caractérisé en ce que le substrat (1) est dopé dans la couche (8) avec des atomes étrangers de façon à prendre une conductivité-n$^+$, en ce que la structure semiconductrice a la structure d'une diode-Schottky et en ce qu'une électrode (4 ; 4') constitue, dans la zone de la fenêtre d'entrée (2), un contact-Schottky (12) avec le volume détecteur (17).

**4.** Photodétecteur selon la revendication 1 ou 2, caractérise en ce que le substrat (1) est dopé dans la couche (8) avec des atomes étrangers de façon à prendre une conductivité-n$^+$, en ce que la structure semiconductrice a la structure d'une transition-PN (22) et en ce qu'il est prévu entre la fenêtre d'entrée (2) et le volume détecteur (17) une couche-p$^{++}$ (23) fortement dopée, qui constitue la transition-PN (22) avec la couche (8).

5. Photodétecteur selon la revendication 1, caractérisé en ce que la structure semiconductrice a la structure d'une diode-PIN, en ce qu'il est prévu directement en dessous de la fenêtre d'entrée (2) une couche-p$^{++}$ (23) fortement dopée, en ce qu'il existe une transition-PN (22) entre la couche-p$^{++}$ (23) et le volume détecteur (17 ), en ce que la concentration des atomes étrangers pour produire la couche (8) avec le dopage-n$^+$ produit dans le substrat (1) de conductivité positive est inférieure à $10^{17}$cm$^{-3}$ et atteint un maximum d'environ $10^{18}$cm$^{-3}$ dans la zone du seuil de potentiel (16), une région (38) quasi-intrinsèquement conductrice produisant une séparation de la couche-p$^{++}$ (23) et de la couche n$^+$ (8) et en ce que la région (38) quasi-intrinsèquement conductrice a une épaisseur de 30 nm à 60 nm.

6. Photodétecteur selon la revendication 1 ou 2, caractérisé en ce que la structure semiconductrice est une structure-MOS, en ce que la couche de conductivité-n$^+$ (8) ou de conductivité-p$^+$ (27) est située directement en dessous d'une grille (28) métalliquement conductrice, perméable au rayonnement (5) et isolée du substrat (1) au moyen d'une couche de recouvrement (3), et en ce que le volume détecteur (17) constitue le canal de conduction-p$^+$ ou de conduction-n$^+$ de la structure-MOS.

7. Photodétecteur selon la revendication 6, caractérise en ce que la couche (27) de conductivité -n$^+$ ou de conductivité-p$^+$ est délimitée latéralement au moyen d'un contact n$^{++}$ ou p$^{++}$ métalliquement conducteur, le volume détecteur (17) constituant le diélectrique d'un condensateur forme par la structure-MOS et dont la capacité est fonction des porteurs de charge créés dans le volume détecteur (17) par le rayonnement (5).

8. Photodétecteur selon la revendication 6, caractérisé en ce que la structure-MOS comporte deux barrettes de conductivité-p$^+$ ou de conductivité -n$^+$ et dont l'une est en contact avec un conducteur de source (32) et l'autre avec un conducteur de drain (33), en ce que la couche (27) de conductivité-n$^+$ ou de conductivité-p$^+$ s'étend entre deux barrettes (31) de conductivité-p$^+$ ou de conductivité-n$^+$ et en ce que le volume détecteur (17) constitue entre les deux barrettes (31) une résistance électrique qui dépend de l'intensité du rayonnement (5).

9. Photodétecteur selon une des revendications 1 à 8, caractérisé en ce que la fenêtre d'entrée (2) est recouverte d'une couche antiréflexion (24).

10. Photodétecteur selon une des revendications 1 à 8, caractérisé en ce que la fenêtre d'entrée (2) est recouverte par un filtre d'interférence (39), qui est transparent pour un rayonnement (5) d'une longueur d'onde de 300 nm et qui arrête efficacement un rayonnement (5) de grande longueur d'onde.

11. Photodétecteur selon une des revendications 1 à 9, caractérisé en ce que le substrat (1) est formé de silicium.

12. Procédé de fabrication d'un photodétecteur selon la revendication 1 ou 2, caractérisé en ce que, avant la formation d'une couche de revêtement (3), le côté avant du substrat (1) est dopé, dans la zone de la fenêtre d'entrée (2), au moyen d'une implantation ionique effectuée avec des atomes étrangers jusqu'à une dose d'environ $10^{13}$cm$^{-2}$ et en ce que, au moyen d'un processus de recuit à 1000°C pendant environ 30 minutes, la pénétration des atomes étrangers par diffusion dans le substrat (1) est contrôlée à partir du côté avant, jusqu'à ce que le seuil de potentiel (16) ait atteint la profondeur prédéterminée ($x_p$ ou $x_m$ ) de 50 nm à 200 nm.

13. Procédé selon la revendication 12, caractérisé en ce que, sur le côté avant du substrat (1) ou d'une région (26), qui ont soit une conductivité négative soit une conductivité positive, la couche dégagée (8) est dopée pour prendre une conductivité -n$^+$, en ce qu'ensuite la couche isolante de recouvrement (3) est produite sur le côté avant, en ce qu'au moyen d'un processus photolithographique au moins une fenêtre d'entrée (2) est découpée dans la couche de recouvrement (3) et en ce que la couche-n$^+$ dégagée (8) est mise au contact d'un conducteur électrique (4 ; 4' ; 23) au moyen d'un contact non ohmique (12 ; 22), qui est perméable au rayonnement (5).

14. Procédé selon la revendication 12, caractérisé en ce que le côté avant du substrat (1) ou de la région (26), de conductivité positive ou de conductivité négative, sont dopés pour prendre une conductivité-n$^+$ ou une conductivité-p$^+$ et en ce qu'ensuite un contact est établi avec le volume détecteur (17), le côté avant est recouvert par une couche isolante de recouvrement (3) et, dans la zone de la fenêtre d'entrée (2) est produite une grille (28) isolée et perméable au rayonnement (5).

15. Procédé de fabrication d'un photodétecteur selon la revendication 5, caractérisé en ce que sur le côté avant du substrat (1) de conductivité positive est produite une couche de recouvrement (3), perméable au rayonnement (5) dans la zone de la fenêtre d'entrée (2), en ce que le substrat (1) est dopé par des ions à travers la couche de recouvrement (3), la couche (8) prenant une conductivité-n$^+$, les îlots (34) prenant une conductivité-n$^{++}$ et la couche-p$^{++}$ (23) et les contacts-p$^{++}$ (29) prenant une conductivité-p$^{++}$, et en ce que, pour produire le seuil de potentiel (16) dans la couche (8) de conductivité-n$^+$ un maximum de concentration des atomes étrangers est atteint à la profondeur prédéterminée ($x_p$).

# Fig. 1

# Fig. 2

# Fig. 3

# Fig. 4

# Fig. 5

EP 0 296 371 B1

# Fig. 6

# Fig. 7

# Fig. 8

14

Fig.9

41
40
} 39

3
34
4
29
2; 24
5
23
22
3
8
1

Fig.10

log (n)

$10^{19}$

$10^{17}$

$10^{15}$

36

35

37

x

2    23    22,38    8    1

Fig.11

E

13

19

16

15

14

18

x

5

2    23    38    8    1

17